# EUROPEAN PATENT SPECIFICATION

(11) **EP 0 631 189 B1**
(45) Date of publication and mention of the grant of the patent: **17.02.1999**
(21) Application number: 93201830.2
(22) Date of filing: 24.06.1993
(51) Int. Cl.: G03F 7/021, G03F 7/004

(54) **Improvement of the storage stability of a diazo-based imaging element for making a printing plate**
Verbesserung der Lagerungsstabilität eines Diazo-Aufzeichnungselementes zur Herstellung einer Druckplatte
Amélioration de la stabilité au stockage pour éléments à base de composés diazo pour la fabrication d'une plaque d'impression

(43) Date of publication of application: 28.12.1994
(73) Proprietor: AGFA-GEVAERT N.V., 2640 Mortsel (BE)
(72) Inventor: Vermeersch, Joan c/o Agfa-Gevaert N.V.,, B-2640 Mortsel (BE); Hauquier, Guido c/o Agfa-Gevaert N.V.,, B-2640 Mortsel (BE); Kokkelenberg, Dirk c/o Agfa-Gevaert N.V.,, B-2640 Mortsel (BE); Verschueren, Eric c/o Agfa-Gevaert N.V.,, B-2640 Mortsel (BE); Dewanckele, Jean-Marie Agfa-Gevaert N.V.,, B-2640 Mortsel (BE)

(56) References cited:
- EP-A- 0 012 905
- EP-A- 0 149 490
- EP-A- 0 450 199
- EP-A- 0 514 990
- DE-A- 3 215 112
- FR-A- 2 175 955
- GB-A- 1 064 100
- US-A- 2 286 215
- US-A- 4 013 696
- DATABASE WPI Derwent Publications Ltd., London, GB; AN 91-226950 & JP-A-3 146 389 (ITSUBISHI KASAEI CORP.)

## Description

### 1. Field of the invention.

The present invention relates to a diazo sensitized imaging element which is developable by plain water to a lithographic printing plate.

### 2. Background of the invention.

Lithography is the process of printing from specially prepared surfaces, some areas of which are capable of accepting lithographic ink, whereas other areas, when moistened with water, will not accept the ink. The areas which accept ink form the printing image areas and the ink-rejecting areas form the background areas.

In the art of photolithography, a photographic material is made imagewise receptive to oily or greasy inks in the photo-exposed (negative-working) or in the non-exposed areas (positive-working) on a hydrophilic background.

In the production of common lithographic printing plates, also called surface litho plates or planographic printing plates, a support that has affinity to water or obtains such affinity by chemical treatment is coated with a thin layer of a photosensitive composition. Coatings for that purpose include light-sensitive polymer layers containing diazo compounds, dichromate-sensitized hydrophilic colloids and a large variety of synthetic photopolymers.

Particularly diazo-sensitized systems are widely used. These systems have been extensively reviewed by Kosar J. in "Light-Sensitive Systems", Wiley, New York, 1965, Chapter 7. A generally used negative-working diazo-sensitized system is based on the capability of diazo compounds to harden a polymer when exposed to ultraviolet and blue radiation. Diazo compounds which have been used for the preparation of lithographic printing plates based on their hardening properties are e.g. diazonium salts whose photolysis products can harden polymers (natural colloids or synthetic resins) directly and diazonium polymers. Although polymers containing diazonium groups have a large structure they remain water soluble owing to the presence of the ionic diazonium groups. When these groups are destroyed by exposure to light an insoluble resin is formed. Particularly useful diazonium polymers are the condensation products of a carbonyl compound, e.g. an aldehyde, such as formaldehyde, with a diazonium salt of e.g. a p-aminodiphenylamine. These condensation products are usually designated diazo resins. In these systems a polymeric binder is optionally added to the diazo resin coating.

Several types of supports can be used for the manufacturing of a diazo-sensitized lithographic printing plate. Common supports are metal supports like Al or Zn, polyester film supports and paper bases. These supports, if not sufficient hydrophilic by themselves, are first coated with a hydrophilic layer to form the hydrophilic background of the printing plate and a top layer containing the diazo compound is then applied (see for example DE-P-1900469, DE-P-2030634 and US-P-3971660).

It is known to use as hydrophilic layer in these systems a layer containing polyvinyl alcohol and hydrolyzed tetraethyl orthosilicate and preferably also silicium dioxide and/or titanium dioxide as described in e.g. GB-P-1419512, FR-P-2300354, US-P-3971660 and 4284705. This hydrophilic layer is overcoated with a light-sensitive layer containing a diazonium salt or a diazo resin in a polymeric binder.

Upon image-wise exposure of the light-sensitive layer the exposed image areas become water insoluble and the unexposed areas remain water soluble. The plate is then developed with water to remove the diazonium salt or diazo resin in the unexposed areas. Such development may take place by means of plain water as disclosed in e.g. EP-A-450199 and EP92203835.1.

It has however been found that the lithographic properties of a lithographic printing plate obtained from diazo based imaging elements in particular those disclosed in e.g. EP-A-450199, EP92203835.1 and US-P-3971660 decrease upon storage of the imaging element.

### 3. Summary of the invention.

It is an object of the present invention to provide a diazo based imaging element for producing a lithographic printing plate having an improved storage stability.

Other objects will become apparent from the description hereinafter.

According to the present invention an imaging element comprising on a hydrophilic support a hydrophilic layer and a light sensitive layer containing a diazo resin or a diazonium salt and an intermediate layer between said hydrophilic layer and said light sensitive layer, said intermediate layer containing an organic compound having cationic groups, characterized in that said light sensitive layer contains as a binder a polyvinylacetate hydrolysed to an extent of at least 95% by weight and a cationic fluor-containing surfactant.

According to the present invention there is provided a method for obtaining a lithographic printing plate comprising the steps of image-wise exposing an imaging element as defined above and subsequently removing the light sensitive layer in the non-exposed or insufficiently exposed areas of said imaging element by means of rinsing or washing said imaging element with plain water.

### 4. Detailed description

It has been found that the storage stability of a diazo based imaging element can be improved by using as a binder in the light sensitive layer a polyvinylacetate hydrolysed to an extent of at least 95% by weight and further containing a cationic fluor containing surfactant. As a consequence, the lithographic properties such as printing endurance, ink acceptance by the printing areas and ink repellance by the non-printing areas remain much more stable upon storage of the imaging element before imaging.

Most preferably the binder of the light sensitive layer is a polyvinyl acetate hydrolysed to an amount of 97% to 100% by weight. Preferably the number average molecular weight of the polyvinylacetate is at least 35000 g/mol and more preferably at least 50000 g/mol. The cationic fluor containing surfactant for use in the light sensitive layer is preferably a perfluorinated surfactant and more preferably a perfluorinated ammonium surfactant. Typical examples of perfluorinated ammonium surfactants are:
n.C₈F₁₇SO₂NH-(CH₂)₃N⁺(CH₃)₃I⁻ (Fluorad FC 135 from 3M)
n.C₉F₁₉SO₂NH-(CH₂)₄N⁺(CH₃)₃Br⁻
n.C₇F₁₅CONH-(CH₂)₃N⁺(CH₃)₃I⁻
(n.C₈F₁₇COO-(CH₂)₄)₂N⁺(CH₃)₂I⁻

The cationic fluor containing surfactant is preferably used in amount of 3mg/m² to 100mg/m² more preferably between 5mg/m² to 55mg/m².

Examples of low-molecular weight diazonium salt for use in the present invention include: benzidine tetrazoniumchloride, 3,3'-dimethylbenzidine tetrazoniumchloride, 3,3'-dimethoxybenzidine tetrazoniumchloride, 4,4'-diaminodiphenylamine tetrazoniumchloride, 3,3'-diethylbenzidine tetrazoniumsulfate, 4-aminodiphenylamine diazoniumsulfate, 4-aminodiphenylamine diazoniumchloride, 4-piperidino aniline diazoniumsulfate, 4-diethylamino aniline diazoniumsulfate and oligomeric condensation products of diazodiphenylamine and formaldehyde.

Examples of diazo resins useful in the present invention include condensation products of an aromatic diazonium salt as the light-sensitive substance. Such condensation products are known and are described, for example, in German Pat. no. 1214086. They are in general prepared by condensation of a polynuclear aromatic diazonium compound, preferably of substituted or unsubstituted diphenylamine-4-diazonium salts, with active carbonyl compounds, preferably formaldehyde, in a strongly acid medium.

The light sensitive layer according to the present invention preferably also contains dispersed water-insoluble polymers. Said aqueous dispersion of water insoluble polymer is preferably cationic or nonionic either e.g. as a result of an emulsifier or by having the cationic or nonionic group linked to the polymer. The water insoluble polymer is preferably a solid particulate having a size in the range of about 100 Angstroms to 1 micron in diameter and does not form a film below 30 °C. In general, any polymer which carries a cationic or nonionic group or which can be formulated into an emulsion using a cationic or nonionic emulsifier can be employed in the present invention. Suitable polymers include homopolymers and copolymers of styrene, methylacrylate, ethylacrylate, butylacrylate, methylmethacrylate, ethylmethacrylate, butyl methacrylate, vinyl acetate, vinyl chloride, vinylidene chloride, butadiene, methyl styrene, vinyl toluene, dimethylaminoethyl acrylate, acrylic acid, methacrylic acid, isoprene, chloroprene, malei anhydride, ethylene glycol acrylates such as polyethylene glycol acrylate, halogenated vinyl aromatics such as chlorostyrene and bromostyrene, methylvinyl ether, vinyl pyrrolidone and polyurethane.

The thickness of the light-sensitive layer in the material of this invention may vary in the range of 0.1 to 10 um and is preferably between 0.5 and 2.5 um.

Hydrophilic supports for use in connection with the present invention are supports having a hydrophilic surface e.g. a roughened and anodized aluminium support or supports that are rendered hydrophilic by means of a hydrophilic layer provided on at least one surface of the support.

Supports that can be provided with a hydrophilic layer are e.g. photographic film bases e.g. substrated polyethylene terephthalate film, cellulose acetate film, plastics having a metal layer or deposit thereon, a metal support, e.g. aluminium and polyolefin (e.g. polyethylene) coated paper, the polyolefin surface of which may have been subjected to a corona discharge to improve the adherence of a hydrophilic layer.

As hydrophilic (co)polymers in said hydrophilic layer one may use, for example, homopolymers and copolymers of vinyl alcohol, acrylamide, methylol acrylamide, methylol methacrylamide, acrylic acid, methacrylic acid, hydroxyethyl acrylate, hydroxyethyl methacrylate or maleic anhydride/vinylmethylether copolymers. The hydrophilicity of the (co)polymer or (co)polymer mixture used is the same as or higher than the hydrophilicity of polyvinyl acetate hydrolyzed to at least an extent of 60 percent by weight, preferably 80 percent by weight.

Examples of hydrolyzed tetraalkyl orthosilicate crosslinking agents are hydrolyzed tetraethyl orthosilicate and hydrolyzed tetramethyl orthosilicate.

The amount of tetraalkyl orthosilicate crosslinking agent is preferably at least 0.2 parts by weight per part by weight of hydrophilic (co)polymer, more preferably between 0.5 and 5 parts by weight, most preferably between 1.0 parts by weight and 3 parts by weight.

Said hydrophilic layer preferably also contains substances that increase the mechanical strength and the porosity of the layer. For this purpose colloidal silica may be used. The colloidal silica employed may be in the form of any commercially available water-dispersion of colloidal silica for example having an average particle size up to 40 nm, e.g. 20 nm. In addition inert particles of larger size than the colloidal silica can be added e.g. silica prepared according to Stöber as described in J. Colloid and Interface Sci., Vol. 26, 1968, pages 62 to 69 or alumina particles or particles having an average diameter of at least 100 nm which are particles of titanium dioxide or other heavy metal oxides. By incorporating these particles the surface of the layer is given a uniform rough texture consisting of microscopic hills and valleys, which serve as storage places for water in background areas.

The thickness of the hydrophilic layer may vary in the range of 0.2 to 25 um and is preferably 1 to 10 um.

In accordance with the invention there is provided an intermediate layer of an organic compound having cationic groups between the hydrophilic surface of the support and light sensitive layer. As a consequence the development by plain water of such a diazo based imaging element is improved.

Organic compounds having cationic groups for use in the intermediate layer are preferably hydrophilic and may be low moleculair weight compounds but are preferably polymers. Preferred compounds are those having one or more ammonium groups or amino groups that can be converted to ammonium groups in an acidic medium. An especially preferred type of cationic compounds are polysacharides modified with one or more groups containing an ammonium or amino group.

Most preferred organic compounds having cationic groups are dextrans or pullulan wherein at least some of the hydroxy groups of the dextran or pullulan has been modified into one or more of the following groups:

-O-R¹

-O-CO-R²

wherein R¹ represents an organic residue containing an amino or ammonium group, e.g. an amine substituted alkyl and an amine substituted alkylaryl.
R² has one of the significances given for R¹ or stands for -OR³ or -N(R⁴)R⁵, wherein R³ has one of the significances given for R¹ and each of R⁴ and R⁵ which may be the same or different and have one of the significances given for R¹.

Pullulan is a polysacharide that is produced by micro-organisms of the Aureobasidium pullulans type (Pullularia pullulans) and that contains maltotriose repeating units connected by a α-1,6 glycosidic bond. Pullulan is generally produced on industrial scale by fermentation of partially hydrolysed starch or by bacterial fermentation of sucrose. Pullulan is commmercially available from e.g. Shodex, Pharmacosmos.

Examples of dextrans or pullulan that can be used in accordance with the present invention are dextrans or pullulan wherein some of the hydroxyl groups have been modified in one of the groups shown in table 1.

**Table 1**

| no. | modified group |
|---|---|
| 1 | -O-CH₂-CH₂-NH₂ |
| 2 | -O-CO-NH-CH₂-CH₂-NH₂ |
| 3 | -O-CO-NH-CH₂-CH₂-N(CH₂-CH₂-NH₂)₂ |
| 4 | -O-CH₂-CH₂-NH-CH₂-CH₂-NH₂ |
| 5 | -O-CH₂-CH₂-NH-CH₂-CHOH-CH₂N⁺(CH₃)₃ Cl⁻ |
| 6 | -O-(CH₂-CH₂-O)ₙ-CH₂-CH₂-NH₂ |
| | wherein n represents an integer from 1 to 50 |
| 7 | -O-CO-NH-CH₂-CH₂-NH-CH₂-CHOH-CH₂-N⁺(CH₃)₃ Cl⁻ |
| 8 | -O-CH₂-CH₂-N(CH₂-CH₃)₂ .HCl |
| 9 | -O-CH₂-CH₂-N(CH₂-CH₂-NH₂)₂ |
| 10 | -O-CONH-CH₂-CH₂-N(CH₂-CH₂-NH₂)₂ |
| 11 | -O-CONH-(CH₂-CH₂-O)ₙ-CH₂-CH₂-NH₂ |

The modified dextrans or pullulan can be prepared by a reaction with e.g. alkylating agents, chloroformates, acid halides and carboxylic acids.

The intermediate layer containing the organic compound having one or more cationic groups is preferably provided in an amount of 5 to 500mg/m² and more preferably in an amount of 10 to 200mg/m².

The imaging element in connection with the present invention advantageously contains water-soluble dyes such as rhodamines, sudan blue, methylen blue, eosin or trifenylmethane dyes such as crystal violet, victoria pure blue, malachite green, methylviolet and fuchsin or dye pigments. These colorants may be incorporated in the light sensitive layer and/or hardened hydrophilic layer when present.

To obtain a lithographic printing plate from an imaging element according to the invention said imaging element is image-wise exposed and subsequently rinsed or washed preferably with plain water to remove diazo resin or diazonium salts in the non-exposed or insufficiently exposed parts of the imaging element.

The exposure of the imaging element used in the present invention advantageously proceeds with ultraviolet light optionally in combination with blue light in the wavelength range of 250 to 500 nm. Useful exposure sources are high or medium pressure halogen mercury vapour lamps, e.g. of 1000 W. Since most lithography is done by the offset process, the imaging element is preferably exposed in such a way that the image obtained thereon is right reading. The exposure may be an exposure using optics or a contact exposure.

The diazo resin or diazonium salts are converted upon exposure from water soluble to water insoluble (due to the destruction of the diazonium groups) and additionally the photolysis products of the diazo may induce an advancement in the level of crosslinking of the polymeric binder or diazo resin, thereby selectively converting the surface, in an image pattern, from water soluble to water insoluble. The unexposed areas remain unchanged, i.e. water soluble.

The following examples illustrate the present invention without being limited thereto. The percentages given are by weight unless otherwise stated.

### EXAMPLE

### Preparation of a lithographic base

To 440 g of a dispersion contg. 21.5% TiO₂ (average particle size 0.3 to 0.5 um) and 2.5% polyvinyl alcohol in deionized water were subsequently added, while stirring, 250 g of a 5% polyvinyl alcohol solution in water, 105 g of a hydrolyzed 22% tetramethylorthosilicate emulsion in water and 12 g of a 10% solution of a wetting agent.
To this mixture was added 193 g of deionized water and the pH was adjusted to pH=4.

The obtained dispersion was coated on a polyethyleneterephthalate film support (coated with a hydrophilic adhesion layer) to a wet coating thickness of 50 g/m², dried at 30 °C. and subsequently hardened by subjecting it to a temperature of 57 °C for 1 week.

To this base was further provided an aqueous solution of (pH=5) of Dormacid (a dextran modified with a diethylaminoethylgroup available from Pfeifer & Langen) and a cationic wetting agent to a dry coating thickness of 100 mg Dormacid per m².

The obtained element was then heated for 1 week at 57 °C.

### Preparation of the imaging elements

An imaging element according to the invention was produced by preparing the following light sensitive composition and coating it to the above described lithographic base in an amount of 35g/m² (wet coating amount) and drying it at 30°C.

Preparation of the light sensitive coating:

To 63g of a 20% dispersion of polymethylmethacrylate (particle diameter of 40nm) stabilized with cetyltrimethylammoniumbromide in deionized water was subsequently added, while stirring, 120 g of a 5% solution of a 98% hydrolized polyvinylacetate, having a number average molecular weight of 90 000g/mol (POLYVIOL W48/20 available from Wacker), in water and 15 g of a 10% dispersion of heligen blue (BASF) in water. 66 g of a 15% solution of the condensationproduct of diphenylamine diazonium salt and formaldehyde in water was then slowly added. Finally 30 g of a 1.6% solution of cationic fluor containing surfactant (Fluorad FC135 available from 3M) in water, and 726 ml of water were added.

3 comparitive imaging elements were prepared similar to the above imaging element but with the following modifications:
- comparative 1:: 10g of a 5% solution in water of a non-ionic fluor containing surfactant C₁₇F₁₅CONH(CH₂-CH₂O)₁₇-H was used instead of the cationic fluor containing surfactant and 746ml of water were subsequently added instead of 726ml.
- comparative 2:: a 88% hydrolysed polyvinylacetate having a weight average molecular weight of 84 000g/mol (MOWIOL 18/88 available from Hoechst) was used instead of the 98% hydrolysed polyvinylacetate.
- comparative 3:: cetyltrimethylammonium bromide was used instead of the cationic fluor containing surfactant. A bad coating of the light sensitive layer was found.

Each of the above described imaging elements except comparitive 3 were stored for 48 hours at 57°C. They were then exposed through a mask to a high pressure halogen mercury vapour lamp of 1000W at a distance of 70cm for 90s.

Subsequently the imaging elements were developed by rinsing with plain water and used to print on an offset press running with a commonly employed ink and fountain solution.

It was found that the printing plate obtained with the imaging element according to the invention could be used to print 10000 copies of excellent quality without ink acceptance in the non-image areas whereas the plate obtained with comparitive 1 yielded only 250 copies of acceptable quality due to ink acceptance in the non-image areas. The lithographic printing plates obtained with comparitive 2 were insufficiently developed resulting in ink acceptance in the non-image areas from the start of the printing process.

## Claims

1. An imaging element comprising on a hydrophilic support a hydrophilic layer and a light sensitive layer containing a diazo resin or a diazonium salt and an intermediate layer between said hydrophilic layer and said light sensitive layer, said intermediate layer containing an organic compound having cationic groups, characterized in that said light sensitive layer contains as a binder a polyvinylacetate hydrolysed to an extent of at least 95% by weight and a cationic fluor-containing surfactant.

2. An imaging element according to claim 1 wherein said hydrophilic support comprises a support provided with a hydrophilic layer containing a hydrophilic (co)polymer or (co)polymer mixture and having been hardened with a hydrolysed tetraalkyl orthosilicate crosslinking agent.

3. An imaging element according to claim 1 or 2 wherein said polyvinylacetate is hydrolysed to an extent of at least 97% by weight.

4. An imaging element according to any of the above claims wherein said fluor-containing surfactant is a perfluorinated ammonium surfactant.

5. A method for making a lithographic printing plate comprising the steps of image-wise exposing an imaging element as defined in any of the above claims and subsequently developing a thus obtained image-wise exposed imaging element by means of plain water.

## Patentansprüche

1. Ein Aufzeichnungselement, das auf einem hydrophilen Träger eine hydrophile Schicht, eine lichtempfindliche Schicht mit einem Diazoharz oder einem Diazoniumsalz und zwischen der hydrophilen Schicht und der lichtempfindlichen Schicht eine Zwischenschicht enthält, wobei die Zwischenschicht eine organische Verbindung mit kationischen Gruppen enthält, dadurch gekennzeichnet, daß die lichtempfindliche Schicht als Bindemittel ein zu wenigstens 95 Gew.-% hydrolysiertes Polyvinylacetat und ein kationisches fluorhaltiges Tensid enthält.

2. Aufzeichnungselement nach Anspruch 1, dadurch gekennzeichnet, daß der hydrophile Träger einen Träger mit einer hydrophilen Schicht umfaßt, die ein hydrophiles (Co)polymeres oder (Co)polymergemisch enthält und mit einem hydrolysierten Tetraalkylorthosilikat-Vernetzungsmittel gehärtet ist.

3. Aufzeichnungselement nach Anspruch 1 oder 2, dadurch gekennzeichnet, daß das Polyvinylacetat zu wenigstens 97 Gew.-% hydrolysiert ist.

4. Aufzeichnungselement nach irgendeinem der vorstehenden Ansprüche, dadurch gekennzeichnet, daß das fluorhaltige Tensid ein perfluoriertes Ammoniumtensid ist.

5. Ein Verfahren zur Herstellung einer lithografischen Druckplatte, wobei ein in irgendwelchem der obigen Ansprüche definiertes Aufzeichnungselement bildmäßig belichtet und danach das so erhaltene bildmäßig belichtete Aufzeichnungselement mit Leitungswasser entwickelt wird.

## Revendications

1. Elément formateur d'image comprenant, sur un support hydrophile, une couche hydrophile et une couche photosensible contenant une résine diazoïque ou un sel de diazonium et une couche intermédiaire entre ladite couche hydrophile et ladite couche photosensible, ladite couche intermédiaire contenant un composé organique possédant des groupes ioniques, caractérisé en ce que ladite couche photosensible contient, à titre de liant, un acétate de polyvinyle hydrolysé jusqu'à concurrence d'au moins 95% en poids et un agent tensioactif cationique fluoré.

2. Elément formateur d'image selon la revendication 1, dans lequel ledit support hydrophile comprend un support muni d'une couche hydrophile contenant un (co)polymère hydrophile ou un mélange de (co)polymères hydrophiles et qui a été durcie avec un agent de réticulation hydrolysé d'orthosilicate de tétraalkyle.

3. Elément formateur d'image selon la revendication 1 ou 2, dans lequel ledit acétate de polyvinyle est hydrolysé jusqu'à concurrence d'au moins 97% en poids.

4. Elément formateur d'image selon l'une quelconque des revendications ci-dessus, dans lequel ledit agent tensioactif fluoré est un agent tensioactif d'ammonium perfluoré.

5. Procédé pour fabriquer un cliché d'impression lithographique, comprenant les étapes consistant à exposer en forme d'image un élément formateur d'image tel que défini dans l'une quelconque des revendications ci-dessus et développer par la suite un élément formateur d'image exposé en forme d'image ainsi obtenu, en utilisant de l'eau ordinaire.
